# EUROPEAN PATENT SPECIFICATION

(11) **EP 0 310 412 B1**
(45) Date of publication and mention of the grant of the patent: **13.04.1994**
(21) Application number: 88309089.6
(22) Date of filing: 30.09.1988
(51) Int. Cl.: G11B 7/26, G03F 1/00

(54) **Improvements in photo-masks**
Photomasken
Photomasques

(30) Priority: 30.09.1987 JP 246653/87; 30.09.1987 JP 246654/87; 30.09.1987 JP 246655/87
(43) Date of publication of application: 05.04.1989
(60) Divisional application: 93202205.6
(73) Proprietor: SHARP KABUSHIKI KAISHA, Osaka 545 (JP)
(72) Inventor: Ohta, Kenji, Kitakatsuragi-gun Nara-ken (JP); Hirokane, Junji, Nara-shi Nara-ken (JP); Shibata, Akira, Kitakatsuragi-gun Nara-ken (JP); Van, Kazuo, Nara-shi Nara-ken (JP); Inui, Tetsuya, Nara-shi Nara-ken (JP); Nagahara, Yoshiyuki, Nara-shi Nara-ken (JP); Mieda, Michinobu, Tenri-shi Nara-ken (JP)
(74) Representative: Taylor, Phillip Kenneth

(56) References cited:
- DE-A- 2 438 467
- PATENT ABSTRACTS OF JAPAN vol. 9, no. 232 (P-389)(1955) 18 September 1985, & JP-A-60 86545 (FUJITSU K.K.) 16 May 1985,
- PATENT ABSTRACTS OF JAPAN vol. 9, no. 232 (P-389)(1955) 18 September 1985, & JP-A-60 87327 (AKAI DENKI K.K.) 17 May 1985,
- PATENT ABSTRACTS OF JAPAN vol. 12, no. 313 (P-749)(3160) 25 August 1988, & JP-A-63 81352 (HITACHI LTD) 12 April 1988,
- PATENT ABSTRACTS OF JAPAN vol. 10, no. 9 (P-420)(2066) 14 January 1986, & JP-A-60 166949 (7ATSUSHITA DENSHI KOGYO K.K.) 30 August 1985,
- PATENT ABSTRACTS OF JAPAN vol. 9, no. 199 (P-380)(1922) 16 August 1985, & JP-A-60 63537 (HITACHI SEISAKUSHO K.K.) 11 April 1985,

## Description

This invention relates to a photo-mask that is used in the manufacture of optical memory devices with which information can be optically recorded, reproduced and erased.

A conventional photo-mask is composed of, as shown in Figure 5, a light-permeable substrate 11 and patterned metal films 12 of Ta, Cr, Ti or the like that are buried in the substrate 11. Another conventional photo-mask is composed of, as shown in Figure 6, a light-permeable substrate 11 and patterned metal films 12 that are disposed on the top surface of the substrate 11. When guide grooves with a width of 0.6-1.3um are formed on a glass substrate that constitutes an optical memory device by the use of the photo-mask, the photo-mask must be brought into contact with a photo-resist that has been disposed on the glass substrate, so that the mask-pattern of the metal films 12 can be transferred onto the photo-resist.

When the transference of the photo-mask onto the photo-resist is conducted, the photo-mask is stained because a piece of the photo-resist sticks to the photo-mask and/or dust enters into a gap between the photo-resist and the photo-mask. To remove the stain from the photo-mask, the photo-mask is subjected to an ultrasonic washing treatment, which causes peeling-off of the metal films 12, resulting in a loss of the mask-pattern of the metal films 12. Moreover, when the photo-mask shown in Figure 5 is brought into contact with a photo-resist that has been formed on the glass substrate of an optical memory device, static electricity occurs and is accumulated in the light-permeable substrate 11 that is non-conductive, which causes damage in the metal films 12.

The photo-mask of this invention, which overcomes the above-discussed and numerous other disadvantages and deficiencies of the prior art, comprises a light-permeable substrate, a plurality of light-shielding films that are disposed on said substrate, said light-shielding films forming a mask pattern, and is characterised in that a light-permeable protective film is disposed over the surface of said substrate including said light-shielding films so as to protect said light-shielding films and in that said light-shielding films are buried in said substrate.

The protective film is preferably made of an electrically conductive substance or of a dielectric substance.

The light-shielding films may be buried in said substrate so that the top surface of each of said light-shielding films is flush with the top surface of said substrate.

The light-shielding films may also be buried in said substrate so that the upper portion of each of said light-shielding films projects from the top surface of said substrate.

In one embodiment of the present invention, the photo-mask comprises a light-permeable substrate and a plurality of light-shielding films that form a mask-pattern, wherein said light-shielding films are buried in said substrate so that the outer surface of each of said light-shielding films is either above or below, but is not flush with the top surface of said substrate.

In a preferred embodiment, the light-shielding films are made of a conductive substance and project above the top surface of said substrate.

Thus, the invention described herein makes possible the objectives of (1) providing a photo-mask in which light-shielding films are protected by a protective film so that the light-shielding films cannot be peeled off, resulting in an elongation of the life of the photo-mask; (2) providing a photo-mask in which if the above-mentioned protective film is conductive, when the photo-mask is brought into contact with a photo-resist that has been disposed on the glass substrate of an optical memory device, the said conductive film comes into contact with the said photo-resist, and accordingly static electricity neither arises nor is accumulated in the light-permeable substrate of the photo-mask so that damage of the metal films of the photo-mask can be prevented, resulting in an enlargement of the life of the photo-mask.

This invention will be further illustrated by reference to the accompanying drawings in which:-
Fig. 1 is a sectional view showing a portion of one form of a photo-mask according to the present invention;
Fig. 2 is a graph showing the relationship between the thickness of a conductive film of Ta and the permeability of ultraviolet rays in the cases where the light-permeable film that is disposed on the light-permeable substrate is conductive;
Fig. 3 is a sectional view showing a portion of yet another form of photo-mask according to the present invention;
Fig. 4 is a sectional view showing a portion of a still further form of photo-mask according to the present invention;
Fig. 5 is a sectional view showing a portion of a conventional photo-mask; and
Fig. 6 is a sectional view showing a portion of another conventional photo-mask.

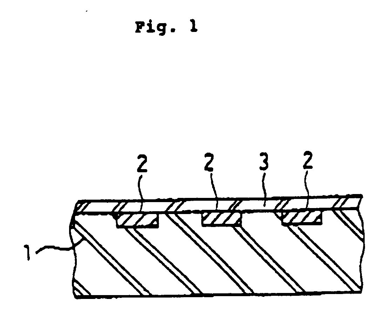

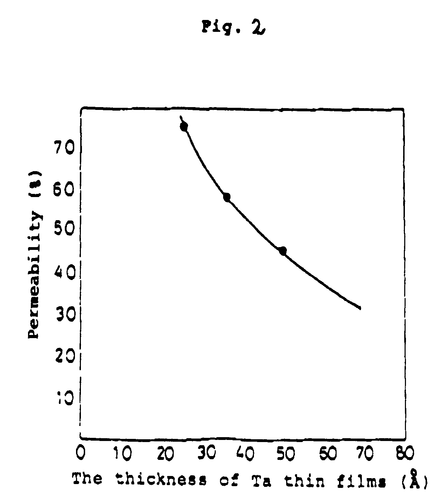

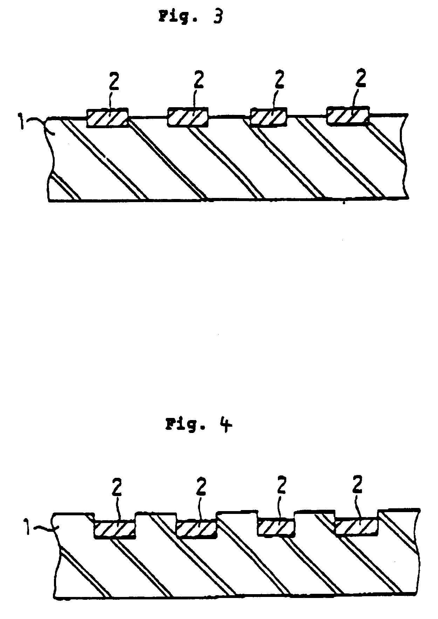

Referring to the accompanying drawings, Fig. 1 shows a photo-mask of this invention, in which a light-permeable substrate 1 made for example of quartz or soda lime, having a plurality of metal films 2 that are buried therein and a light-permeable film 3 that is disposed over the surface of the substrate 1 which includes the metal films 2.

In the embodiment of Fig. 1, one surface of each of the metal films 2 is flush with the surface of the substrate 1 which contains the metal films 2. The metal films 2 may be made of Ta, Ti, Cr, Mo, or like metallic material for shielding light. The metal films 2 can be also made of a substance such as TaSr, MoSi, or the like containing at least one of the above-mentioned metallic materials. In the production of the embodiment of Fig. 1 substrate 1 is etched so as to remove given portions of the substrate 1 corresponding to the desired mask-pattern and the above-mentioned metal film material is then disposed in the etched portions of the substrate 1 to form the light-shielding metal films 2 in the desired mask-pattern. The pattern of metal films 2 shield the substrate 1 from electromagnetic radiation such as ultraviolet rays when the substrate 1 is irradiated with such radiation. When a negative-type photo-resist is used for the manufacture of the guide grooves of an optical memory device, the above-mentioned metal films 2 are located on the portions of the substrate 1 that correspond to the portions of the photo-resist to be removed by a development treatment, whereas when a positive-type photo-resist is used, the above-mentioned metal films 2 are located on the portions of the substrate 1 that correspond to the portions of the photo-resist to remain after a development treatment.

The light-permeable film 3 that functions to protect the metal films 2 is made of a dielectric substance such as SiO₂ or the like. The thickness of the film 3 is preferably about 30-300 nm. When the film 3 is exceedingly thin, the protection of the metal films 2 is reduced. When the SiO₂ film 3 is exceedingly thick, the transference of the mask-pattern of the metal films 2 onto the photo-resist that has been disposed on a glass substrate that constitutes an optical memory device cannot be carried out with absolute accuracy.

Because the metal films 2 are covered with the film 3, even when the photo-mask is subjected to an ultrasonic washing treatment, the metal films 2 are not peeled off. Moreover, when this film 3 is SiO₂ it tends to adhere to an SiO₂ component contained in the substrate 1 when that is made of a glass material such as quartz, soda lime, or the like, so that the SiO₂ film 3 becomes an excellent protective film for protecting the metal films 2.

A photo-mask of the embodiment of Fig. 1 composed of a quartz substrate 1, chromium (Cr) films 2, and an SiO₂ film 3 was used in the production of the guide grooves of the glass substrates of a particular type of optical memory device. Although the transferring process was repeated several thousands of times by the use of the photo-mask of this invention no loss of the mask-pattern of the metal film 2 was observed. On the other hand, the mask-pattern of a reference control photo-mask that had no SiO₂ film 3 was damaged after the transferring process was repeated several times.

The photo-mask of this invention is useful for the manufacture of an optical memory device such as an opto-magnetic disk or the like. In general, the optmagnetic disk has a metal thin film as a memory medium that is made of an alloy of rare earth elements and transition elements. The thin alloy film tends to deteriorate due to moisture and/or oxygen. By the use of the photo-mask of this invention, the glass substrate of an optical memory device is exposed to light to form a latent image corresponding to the guide groove pattern, and the glass substrate is subjected to a development treatment and an etching treatment, resulting in guide grooves in the glass substrate. Then, thin alloy film of rare earth elements and transition elements is formed on the said glass substrate. According to the above-mentioned way, because there is little possibility that oxygen and/or moisture will reach the memory medium through the glass substrate, resulting in a high quality optical memory device.

In addition to SiO₂ the film 3 may be composed of other dielectric substances so long as they are light-permeable, such as for example, a nitride such as AlN, Si₃N₄, TaN, or the like; an oxide such as Al₂O₃, TiO₂, Ta₂O₅, or the like; or an alloy of the above-mentioned metals. Although the above-mentioned metal film 2 is a single film made of the above-mentioned metal, it can be also a double-layered film or a triple-layered film made of the said metal and an oxide of the said metal. Moreover, the light-shielding film is not limited to the metal films 2, but it can be films made of other materials by which light is shielded and by which a mask-pattern can be formed.

In another embodiment of the type illustrated in Fig. 1 the light-permeable film 3 is made of a conductive material such as Ta, Ti, Mo, Ni, AuCr, InO₂, or the like. When the light-permeable film 3 is composed of a Ta thin film, the thickness thereof is set to be, for example, around 2-10 nm.

The Ta thin film 3 of the photo-mask is brought into contact with a photo-resist that has been formed on the glass substrate of an optical memory device, and the glass substrate is irradiated with ultraviolet rays through the photo-mask. Thereafter, the glass substrate is subjected to a development treatment and an etching treatment, resulting in guide grooves in the glass substrate. Because the Ta thin film 3 that is conductive comes into contact with the photo-resist, static electricity neither occurs nor is accumulated in the glass substrate during the light-exposure process.

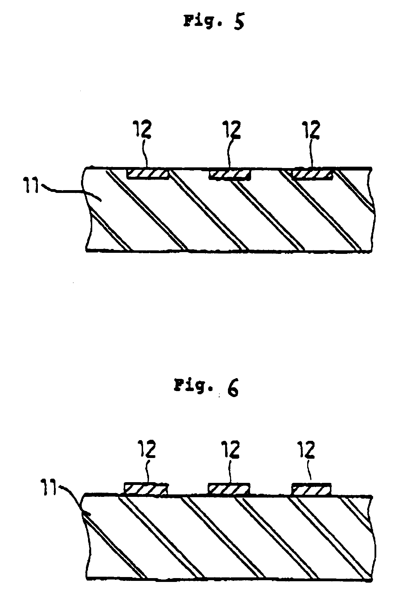

Fig. 2 shows the relationship between the thickness of the Ta thin film 3 and the permeability of ultraviolet rays therethrough, indicating that the permeability of ultraviolet rays is reduced with increasing thickness of the Ta thin film 3. Nevertheless, by increasing the duration of irradiation with ultraviolet rays is increased with increasing thickness of the Ta thin film 3, a sufficient light-exposure can be achieved thus compensating for the reduction in permeability resulting from an increase in the thickness of the Ta film.

Fig. 3 shows another photo-mask of this invention, which comprises a light-permeable substrate 1 made for example of quartz, soda lime, or the like and metal films 2 made for example of a conductive substance such as Ta, Ti, Ni Cr, Co, TaSi, MoSi, or the like. The metal films 2 are buried in the light-permeable substrate 1 such that a portion of each of the metal films 2 project from the surface of the light-permeable substrate 1 which carries the metal films. Accordingly, when the metal films 2 of the photo-mask are brought into contact with a photo-resist that has been formed on the glass substrate of an optical memory device, because the top surface of the light-permeable substrate 1 of the photo-mask keeps away from the photo-resist, occurrence or accumulation of static electricity in the light-permeable substrate 1 of the photo-mask can be suppressed and the metal films 2 are not damaged.

Moreover, when the metal films 2 of the photo-mask are brought into contact with the photo-resist disposed on the glass substrate, because the area of the photo-mask that comes into contact with the photo-resist is smaller than that of a photo-mask in which the surface of each of the metal films 2 is flush with the surface of the substrate 1, the photo-mask of this example can be more readily removed from the photo-resist after the transference of the mask-pattern of the photo-mask onto the photo-resist is carried out.

A photo-mask of the type illustrated in Fig. 3 may also be made with a light-permeable film such as that of Fig. 1 is provided which covers the surface of the substrate 1 which includes the metal films 2.

Fig. 4 shows another photo-mask of this invention, in which the metal films 2 are buried in the light-permeable substrate 1 so that the surface of the substrate 1 is not flush with the surface of each of the metal films 2; namely, the outer surface of each of the metal films is lower than the surface of the substrate 1 which contains the metal films. Thus, when the photo-mask is brought into contact with a photo-resist that has been formed on the glass substrate of an optical memory device, the area of the photo-mask that comes into contact with the photo-resist is smaller than that of the photo-mask in which the top surface of each of the metal films 2 is flush with the top surface of the substrate 1, so that the photo-mask can be readily removed from the photo-resist after the transference of the mask-pattern of the photo-mask onto the photo-resist is carried out.

## Claims

1. A photo-mask comprising a light-permeable substrate (1), a plurality of light-shielding films (2) that are disposed on said substrate, said light-shielding films forming a mask-pattern, characterised in that a light-permeable protective film (3) is disposed over the surface of said substrate including said light-shielding film so as to protect said light-shielding films and in that said light-shielding films (2) are buried in said substrate (1).

2. A photo-mask according to claim 1,
characterised in that said protective film (3) is made of a conductive substance.

3. A photo-mask according to claim 1,
characterised in that said protective film (3) is made of a dielectric substance.

4. A photo-mask according to claim 1, 2 or 3,
characterised in that the outer surface of each of said light-shielding films (2) is flush with the surface of said substrate.

5. A photo-mask according to claim 1, 2 or 3,
characterised in that the upper portion of each of said light-shielding films (2) projects from the surface of said substrate (1).

6. A photo-mask according to claim 2,
characterised in that said conductive substance is one selected from the group consisting of Ta, Ti, Mo, Ni, AuCr and InO₂.

7. A photo-mask according to claim 1,
characterised in that said light-shielding films (2) are made of a metal selected from the group consisting of Ta, Ti, Cr and Mo.

8. A photo-mask according to claim 1,
characterised in that said light-permeable protective film (3) is made of Ta with a thickness of 2 to 10nm.

9. A photo-mask according to claim 1,
characterised in that said protective film (3) is made of the same substance as that of said light-shielding films (2).

10. A photo-mask according to claim 9,
characterised in that said light-shielding films (2) and said protective film (3) are respectively made of a metal.

11. A photo-mask according to claim 10,
characterised in that said metal is Ta or Ti.

12. A photo-mask according to claim 1,
characterised in that said light permeable protective film (3) is made of a dielectric substance.

13. A photo-mask according to claim 12,
characterised in that said dielectric substance is SiO₂.

14. A photo-mask according to claim 12,
characterised in that said dielectric substance is a nitrogen compound selected from the group consisting of AlN, Si₃N₄ and TaN.

15. A photo-mask according to claim 12,
characterised in that said dielectric substance is an oxide selected from the group consisting of Al₂O₃, TiO₂ and Ta₂O₅.

## Patentansprüche

1. Photomaske mit einem lichtdurchlässigen Substrat (1), einer Mehrzahl von lichtabschirmenden Schichten (2), welche auf dem Substrat angeordnet sind, wobei die lichtabschirmenden Schichten ein Masken-Muster bilden, dadurch gekennzeichnet, daß eine lichtdurchlässige Schutzschicht (3) über der Oberfläche des Substrats einschließlich der lichtabschirmenden Schichten angeordnet ist, um so die lichtabschirmenden Schichten zu schützen, und daß die lichtabschirmenden Schichten (2) in dem Substrat (1) eingegraben sind.

2. Photomaske nach Anspruch 1, dadurch gekennzeichnet, daß die Schutzschicht (3) aus einer leitfähigen Substanz hergestellt ist.

3. Photomaske nach Anspruch 1, dadurch gekennzeichnet, daß die Schutzschicht (3) aus einer dielektrischen Substanz hergestellt ist.

4. Photomaske nach Anspruch 1, 2 oder 3, dadurch gekennzeichnet, daß die äußere Oberfläche jeder der lichtabschirmenden Schichten (2) bündig mit der Oberfläche des Substrats ist.

5. Photomaske nach Anspruch 1, 2 oder 3, dadurch gekennzeichnet, daß der obere Bereich jeder der lichtabschirmenden Schichten (2) aus der Oberfläche des Substrats (1) herausragt.

6. Photomaske nach Anspruch 1, dadurch gekennzeichnet, daß die leitfähige Substanz aus der aus Ta, Ti, Mo, Ni, AuCr und InO₂ bestehenden Gruppe ausgewählt ist.

7. Photomaske nach Anspruch 1, dadurch gekennzeichnet, daß die lichtabschirmenden Schichten (2) aus einem aus der Ta, Ti, Cr und Mo aufweisenden Gruppe ausgewählten Metall hergestellt ist.

8. Photomaske nach Anspruch 1, dadurch gekennzeichnet, daß die lichtdurchlässige Schicht (3) aus Ta mit einer Dicke von 2 bis 10 nm hergestellt ist.

9. Photomaske nach Anspruch 1, dadurch gekennzeichnet, daß die Schutzschicht (3) aus der gleichen Substanz wie die lichtabschirmenden Schichten (2) hergestellt ist.

10. Photomaske nach Anspruch 9, dadurch gekennzeichnet, daß die lichtabschirmenden Schichten (2) und die Schutzschicht (3) jeweils aus einem Metall hergestellt sind.

11. Photomaske nach Anspruch 10, dadurch gekennzeichnet, daß das Metall Ta oder Ti ist.

12. Photomaske nach Anspruch 1, dadurch gekennzeichnet, daß die lichtdurchlässige Schutzschicht (3) aus einer dielektrischen Substanz hergestellt ist.

13. Photomaske nach Anspruch 12, dadurch gekennzeichnet, daß die dielektrische Substanz SiO₂ ist.

14. Photomaske nach Anspruch 12, dadurch gekennzeichnet, daß die dielektrische Substanz eine aus der aus AlN, Si₃N₄ und TaN bestehenden Gruppe ausgewählte Stickstoffverbindung ist.

15. Photomaske nach Anspruch 12, dadurch gekennzeichnet, daß die dielektrische Substanz ein aus der aus Al₂O₃, TiO₂ und Ta₂O₅ bestehenden Gruppe ausgewähltes Oxid ist.

## Revendications

1. Photomasque comprenant un substrat perméable à la lumière (1), une pluralité de films formant écran à la lumière (2) disposés sur ledit substrat, lesdits films formant écran à la lumière constituant un dessin de masque, caractérisé en ce qu'un film protecteur perméable à la lumière (3) est disposé sur la surface dudit substrat incluant lesdits films formant écran à la lumière de façon à protéger lesdits films formant écran à la lumière et en ce que lesdits films formant écran à la lumière (2) sont encastrés dans ledit substrat (1).

2. Photomasque selon la revendication 1, caractérisé en ce que ledit film protecteur (3) est constitué d'une substance conductrice.

3. Photomasque selon la revendication 1, caractérisé en ce que ledit film protecteur (3) est constitué d'une substance diélectrique.

4. Photomasque selon la revendication 1, 2, ou 3, caractérisé en ce que la face externe de chacun desdits films formant écran à la lumière (2) affleure la surface dudit substrat.

5. Photomasque selon la revendication 1, 2, ou 3, caractérisé en ce que la partie supérieure de chacun desdits films formant écran à la lumière (2) est en saillie par rapport à la surface dudit substrat (1).

6. Photomasque selon la revendication 2, caractérisé en ce que ladite substance conductrice est choisie dans le groupe constitué par le Ta, le Ti, le Mo, le Ni, l'AuCr et l'InO₂.

7. Photomasque selon la revendication 1, caractérisé en ce que lesdits films formant écran à la lumière (2) sont réalisés dans un métal choisi dans le groupe constitué par le Ta, le Ti, le Cr et le Mo.

8. Photomasque selon la revendication 1, caractérisé en ce que ledit film perméable à la lumière (3) est réalisé en Ta avec une épaisseur de 2 à 10 nm.

9. Photomasque selon la revendication 1, caractérisé en ce que ledit film protecteur (3) est réalisé dans la même substance que celle des films formant écran à la lumière (2).

10. Photomasque selon la revendication 9, caractérisé en ce que lesdits films formant écran à la lumière (2) et ledit film protecteur (3) sont respectivement réalisés en métal.

11. Photomasque selon la revendication 10, caractérisé en ce que ledit métal est du Ta ou Ti.

12. Photomasque selon la revendication 1, caractérisé en ce que ledit film protecteur perméable à la lumière (3) est réalisé dans une substance diélectrique.

13. Photomasque selon la revendication 12, caractérisé en ce que ladite substance diélectrique est du SiO₂.

14. Photomasque selon la revendication 12, caractérisé en ce que ladite substance diélectrique est un composé azoté choisi dans le groupe constitué par l'AlN, le Si₃N₄ et le TaN.

15. Photomasque selon la revendication 12, caractérisé en ce que ladite substance diélectrique est un oxyde choisi dans le groupe constitué par l'Al₂O₃, le TiO₂ et le Ta₂O₅.
